(19) **Europäisches Patentamt**

**European Patent Office**

**Office européen des brevets**

(11) **EP 1 089 288 A1**

(12) **EUROPÄISCHE PATENTANMELDUNG**

(43) Veröffentlichungstag:
04.04.2001 Patentblatt 2001/14

(51) Int. Cl.$^7$: **G11C 11/418**, G11C 11/419

(21) Anmeldenummer: 00118860.6

(22) Anmeldetag: 31.08.2000

(84) Benannte Vertragsstaaten:
**AT BE CH CY DE DK ES FI FR GB GR IE IT LI LU MC NL PT SE**
Benannte Erstreckungsstaaten:
**AL LT LV MK RO SI**

(30) Priorität: **31.08.1999 DE 19941348**

(71) Anmelder: **Micronas GmbH**
**79108 Freiburg (DE)**

(72) Erfinder:
• **Rohrer, Stefan, Dipl.-Ing.**
**79104 Freiburg (DE)**
• **Himmel, Thomas, Dipl.-Ing.**
**77955 Freiburg (DE)**
• **Jünke, Manfred, Dipl.-Ing.**
**79194 Gundelfingen (DE)**

(74) Vertreter:
**Schaumburg, Thoenes & Thurn**
**Postfach 86 07 48**
**81634 München (DE)**

(54) **Speicherzugriffseinheit für den wahlweisen Zugriff auf eine statische Speichereinheit oder eine dynamische Speichereinheit sowie zugehörige Zugriffsverfahren**

(57) Erläutert wird eine Speicherzugriffseinheit (100), die ein Adreßregister (154) und ein Datenregister (156) enthält. Ein Prozessor greift auf diese Register (154, 156) unabhängig von einer Betriebsart für den Zugriff auf eine statische Speichereinheit oder eine dynamische Speichereinheit zu.

Fig. 4A

Fig. 4B

EP 1 089 288 A1

**Beschreibung**

Die Erfindung betrifft eine Speicherzugriffseinheit mit einem inneren Adreßbus, der eine vorgegebene Anzahl innerer Adreßleitungen zum Übertragen eines inneren Adreßwortes enthält. Das Adreßwort wird beispielsweise von einem Prozessor erzeugt. Die Speicherzugriffseinheit enthält außerdem einen inneren Datenbus, der mehrere innere Datenleitungen zum Übertragen eines inneren Datenwortes enthält, das vom Prozessor geschrieben oder gelesen wird. An einem äußeren Adreßbus der Speicherzugriffseinheit werden abhängig von einer gewählten Betriebsart die Adressierungsanschlüsse einer statischen Speichereinheit oder die Adressierungsanschlüsse einer dynamischen Speichereinheit angeschlossen. Der äußere Adreßbus enthält ebenfalls eine vorgegebene Anzahl äußere Adreßleitungen. Die Datenanschlüsse der Speichereinheit sind mit einem äußeren Datenbus der Speicherzugriffseinheit verbunden. Der äußere Datenbus enthält eine vorgegebene Anzahl Datenleitungen zum Übertragen von Daten von oder zur Speichereinheit.

Eine Steuereinheit der Speicherzugriffseinheit steuert abhängig von der gewählten Betriebsart die Weitergabe eines inneren Adreßdatenwortes auf den äußeren Adreßbus sowie die Datenübertragung zwischen innerem Datenbus und äußerem Datenbus.

Ein RAM (Random Access Memory) ist eine Speichereinheit, bei der man nach Vorgabe einer Adresse Daten speichern und unter dieser Adresse wieder lesen kann, sogenannter wahlfreier Zugriff. Man unterscheidet statische RAMs (SRAM-Static Random Access Memory) und dynamische RAMs (DRAM-Dynamic Random Access Memory). Bei statischen Speichereinheiten bleibt der Speicherinhalt ohne zusätzliche Maßnahmen so lange erhalten, wie die Betriebsspannung anliegt. Bei dynamischen Speichereinheiten muß der Speicherinhalt durch Lesezugriffe aufgefrischt werden, die in regelmäßigen Abständen ausgeführt werden müssen, damit der Speicherinhalt nicht verlorengeht.

Zum Betrieb einer statischen Speichereinheit könnte der innere Adreßbus mit dem äußeren Adreßbus verbunden werden. Weiterhin wäre der innere Datenbus mit dem äußeren Datenbus zu verbinden. Beim Betrieb einer dynamischen Speichereinheit wird zwischen innerem Adreßbus und äußerem Adreßbus ein sogenannter Speichercontroler verwendet, der aus dem inneren Adreßwort ein äußeres Zeilenadreßwort zum Adressieren einer Zeile der Speichereinheit und ein äußeres Spaltenadreßwort zum Adressieren einer Spalte der Speichereinheit erzeugt.

Für bekannte Schaltkreise mit einer Speicherzugriffseinheit, an die wahlweise ein SRAM oder ein DRAM angeschlossen werden kann, ist nicht bekannt, wie sie im Inneren aufgebaut sind. Für die Realisierung der Funktion gibt es mehrere Möglichkeiten. Beispielsweise könnte für jede Betriebsart eine eigene Schnittstelleneinheit verwendet werden.

Es ist Aufgabe der Erfindung, eine einfach aufgebaute Speicherzugriffseinheit für den wahlfreien Zugriff auf eine statische Speichereinheit oder eine dynamische Speichereinheit anzugeben. Weiterhin sollen Verfahren angegeben werden, die in der Speicherzugriffseinheit ausgeführt werden.

Die Aufgabe wird für eine Speicherzugriffseinheit durch die im Patentanspruch 1 angegebenen Merkmale erfüllt. Weiterbildungen sind in den Unteransprüchen angegeben.

Die Erfindung geht von der Überlegung aus, daß es wünschenswert ist, einem Kunden die Möglichkeit zu geben, erst kurz vor der Auslieferung eines Gerätes abhängig vom Marktpreis eine statische Speichereinheit oder eine dynamische Speichereinheit in seinem Gerät zu verwenden. Weiterhin geht die Erfindung von der Überlegung aus, daß es wünschenswert ist, daß ein die Speichereinheit verwendender Prozessor unabhängig von der Betriebsart auf die gleiche Art und Weise arbeitet.

Deshalb wird bei der erfindungsgemäßen Speicherzugriffseinheit ein Adreßregister verwendet, dessen Adreßanschlüsse mit dem inneren Adreßbus und dessen Datenanschlüsse mit dem inneren Datenbus verbunden sind. Das Adreßregister dient zum Speichern des an die Speichereinheit weiterzugebenden inneren Adreßwortes, das von der Steuereinheit für den Zugriff verwendet wird. Außerdem wird beim erfindungsgemäßen Verfahren ein Datenregister verwendet, dessen Adreßanschlüsse mit dem inneren Adreßbus und dessen Datenanschlüsse mit dem inneren Datenbus verbunden sind. Das Datenregister wird zum Zwischenspeichern eines bereits über den äußeren Datenbus übertragenen, d.h. aus der Speichereinheit gelesenen, oder noch vom äußeren Datenbus zu übertragenden, d.h. in die Speichereinheit zu schreibenden, Datenwortes verwendet. Der Prozessor greift beim erfindungsgemäßen Verfahren unabhängig von der gewählten Betriebsart stets nur auf das Adreßregister und das Datenregister zu. Die Steuereinheit wertet dann abhängig von der gewählten Betriebsart das im Adreßregister gespeicherte Adreßwort aus und greift auf die Speichereinheit zu. Bei einem Schreibzugriff wird das zuvor vom Prozessor im Datenregister gespeicherte Datenwort am äußeren Datenbus ausgegeben. Bei einem Lesezugriff wird ein Datenwort in der Speichereinheit an der durch das Adreßwort angegebenen Adresse gelesen und in das Datenregister geschrieben. Von dort wird es dann durch den Prozessor ausgelesen.

Der Prozessor ist beim Verwenden der erfindungsgemäßen Speicherzugriffseinheit nicht in der Lage, einen Speicherzugriff innerhalb eines Prozessorzyklusses durchzuführen. Ein Prozessorzyklus ist durch die Zeit festgelegt, die zum Laden des sogenannten Akkumulators benötigt wird. In der erfindungsgemäßen Speicherzugriffseinheit muß der Prozessor zunächst einen Adreßwert im Adreßregister speichern. Dazu muß der Adreßwert auf den inneren Datenbus übertragen werden. Erst danach kann der Zugriff auf das Datenregister erfolgen. Dies ist jedoch dann kein Nachteil, wenn die Speicherzugriffseinheit für eine Anwendung verwendet wird, in der für den Speicherzugriff ausreichend Zeit zur Verfügung steht, beispielsweise das Auslesen einer Videotexttafel.

Befehlsfolgen für den Prozessor können unabhängig von der später an die Speicherzugriffseinheit angeschlossenen Speichereinheit programmiert werden. Dies spart Entwicklungsaufwand. Da es letztlich nur eine Befehlsfolge für beide Speichereinheiten gibt, wird auch Speicherplatz zum Speichern der Befehlsfolge gespart.

Bei einer Weiterbildung der erfindungsgemäßen Speicherzugriffseinheit wird ein erstes Datenregister verwendet, dessen Adresse auf dem inneren Adreßbus beim Schreiben eines inneren Datenwortes anliegt. Die Adresse eines zweiten Datenregisters weicht von der Adresse des ersten Datenregisters ab. Das zweite Datenregister wird beim Lesen eines inneren Datenwortes über den inneren Adreßbus adressiert. Durch diese Maßnahmen wird erreicht, daß bereits durch die Adressierung des Datenregisters festgelegt ist, ob ein Schreibvorgang oder ein Lesevorgang ausgeführt werden soll, die jeweils von der Steuereinheit unterschiedlich behandelt werden. Eine Auswertung des Anschlusses zur Auswahl einer Schreiboperation bzw. einer Leseoperation am Prozessor kann entfallen.

Bei einer Ausgestaltung schreibt die Steuereinheit beim Schreiben eines Datenwortes in das Datenregister dieses Datenwort automatisch in die Speichereinheit an die im Adreßregister gespeicherte Adresse. Beim Lesen des zweiten Datenregisters liest die Steuereinheit automatisch aus der Speichereinheit ein Datenwort aus, das an der im Adreßregister gespeicherten Adresse gespeichert ist. Das ausgelesene Datenwort wird dann im zweiten Datenregister gespeichert. Nach dem Zugriff auf das Datenregister wird somit der Zugriff auf die Speichereinheit automatisch gestartet, ohne daß zusätzliche Signalisierungen erforderlich wären.

Dies führt zu kürzeren Zugriffszeiten. Wird beim Schreiben des Adreßregisters durch die Steuereinheit automatisch aus der Speichereinheit ein Datenwort gelesen, so kann erreicht werden, daß bei einem folgenden Lesezugriff auf das Datenregister dort bereits das an der im Adreßregister gespeicherten Adresse in der Speichereinheit gespeicherte Datenwort gespeichert ist. Ein weiterer Lesezugriff auf das zweite Datenregister kann entfallen.

Der zweite Lesezugriff auf das zweite Datenregister führt zu einer unwesentlichen Verlängerung der Speicherzugriffszeit, wenn mehrere aufeinanderfolgende Adressen der Speichereinheit gelesen werden. In diesem Fall werden die Datenworte mit einer Verzögerung von einem Lesezyklus des zweiten Datenregisters an den Prozessor übertragen.

Um Anschlüsse an der Speicherzugriffseinheit einzusparen, hat bei einer Weiterbildung mindestens eine Leitung des äußeren Adreßbusses oder des äußeren Datenbusses unabhängig von der Betriebsart die gleiche Funktion. Anschlüsse lassen sich auch einsparen, wenn mindestens eine weitere Leitung des äußeren Adreßbusses oder des äußeren Datenbusses abhängig von der Betriebsart verschiedene Funktionen hat. Im letzten Fall sind Funktionen betroffen, die nur in einer Betriebsart benötigt werden.

Wird bei einer Ausgestaltung zwischen innerem und äußerem Datenbus ein Datenwandler geschaltet, der eine Seriell-Parallel- bzw. eine Parallel-Seriell-Wandlung durchführt, so können Speichereinheiten verwendet werden, in die die Daten seriell eingegeben werden müssen bzw. aus denen die Daten seriell ausgelesen werden.

Wird zwischen äußerem Datenbus und innerem Datenbus eine Decodiereinheit zum Erkennen und/oder Korrigieren von Fehlern bei der Übertragung von Datenworten angeordnet, so können Störungen bei der Datenübertragung vermieden werden. Arbeitet die Decodiereinheit mit seriellen Daten, z.B. ein Hammingdecoder, so müssen die Datenworte mit Hilfe eines Parallel-Seriell-Wandlers in serielle Daten umgewandelt werden. Eine Verzögerung beim Lesen der Speichereinheit läßt sich somit nicht vermeiden. In einem solchen Fall kann dem Kunden die Möglichkeit gegeben werden, nicht nur zwischen statischer Speichereinheit und dynamischer Speichereinheit zu wählen, sondern auch zwischen Speichereinheiten, die mit Datenworten unterschiedlicher Wortbreite organisiert sind, d.h. beispielsweise zwischen der Datenwortbreite 1 Bit und der Datenwortbreite 8 Bit zu wählen.

Die Erfindung betrifft außerdem Verfahren zum wahlweisen Zugriff auf eine statische Speichereinheit oder eine dynamische Speichereinheit mit den im Patentanspruch 7 bzw. im Patentanspruch 8 angegebenen Verfahrensschritten. Diese Verfahren hängen technologisch eng mit der Speicherzugriffseinheit zusammen, so daß die oben angegebenen technischen Wirkungen auch für die Verfahren gelten.

Im folgenden werden Ausführungsbeispiele der Erfindung an Hand der beiliegenden Zeichnungen erläutert. Darin zeigen:

Figur 1          eine Speicherzugriffseinheit, an die wahlweise eine statische Speichereinheit oder eine dynamische Speichereinheit angeschlossen wird,

Figur 2          den Aufbau der Speicherzugriffseinheit,

Figur 3          den Aufbau eines zweiten Ausführungsbeispiels der Speicherzugriffseinheit, und

Figuren 4A und 4B    Verfahrensschritte zum automatischen Ermitteln der Betriebsart und der Speicherkapazität einer Speichereinheit.

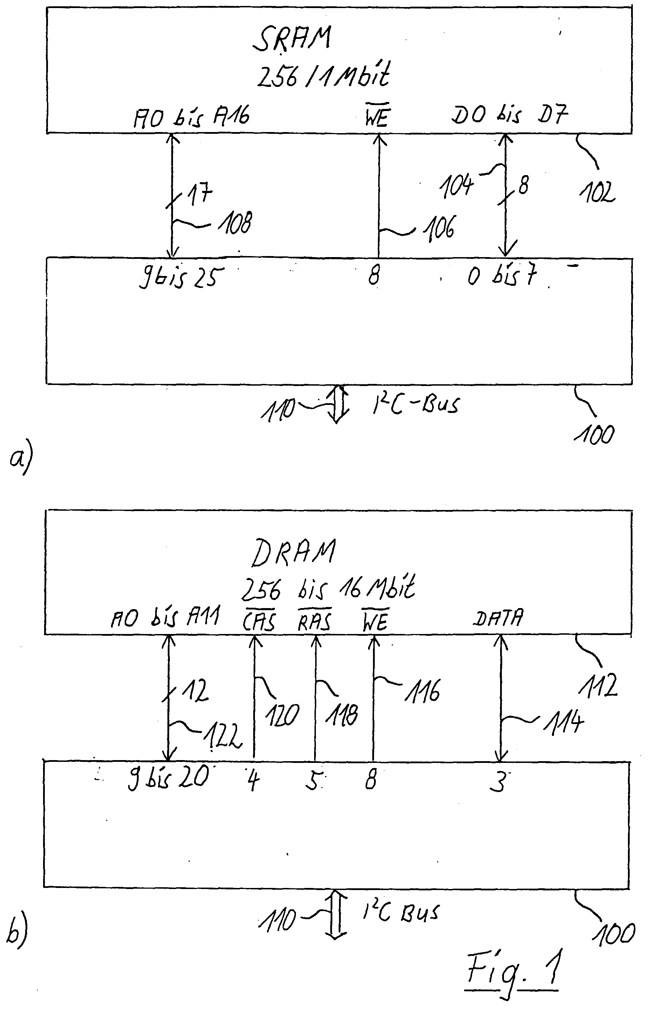

Figur 1 zeigt in einem Teil a eine Speicherzugriffseinheit 100, an die eine statische Speichereinheit 102 (SRAM-Static Random Access Memory) angeschlossen ist.

Die statische Speichereinheit 102 kann eine Speicherkapazität zwischen 256 KBit und einem MBit haben.

Datenanschlüsse D0 bis D7 der statischen Speichereinheit 102 sind über einen äußeren Datenbus 104 mit Datenanschlüssen 0 bis 7 der Speicherzugriffseinheit 100 verbunden. Der äußere Datenbus 104 enthält acht Datenleitungen. Ein Schreib/Lese-Auswahlanschluß $\overline{WE}$ der Speichereinheit 102 ist über eine Steuerleitung 106 mit einem Anschluß 8 der Speicherzugriffseinheit 100 verbunden. Führt die Steuerleitung 106 H-Potential, so befindet sich die Speichereinheit 102 im Lesemodus, d.h. es können Datenworte ausgelesen werden. Befindet sich auf der Steuerleitung 106 L-Potential, so ist die Speichereinheit 102 im Schreibmodus, in welchem Datenworte in die Speichereinheit 102 geschrieben werden.

Adreßanschlüsse A0 bis A16 der Speichereinheit 102 sind mittels eines äußeren Adreßbusses 108 mit Adreßanschlüssen 9 bis 25 der Speicherzugriffseinheit 100 verbunden. Der äußere Adreßbus 108 enthält 17 Datenleitungen.

Aus der Speicherzugriffseinheit 100 führt ein Industriebus 110 heraus, der international standardisiert ist und auch als I$^2$C-Bus bezeichnet wird.

Teil b der Figur 1 zeigt die Zugriffseinheit 100 angeschlossen an eine dynamische Speichereinheit 112 (DRAM-Dynamic Random Access Memory). Die dynamische Speichereinheit 112 hat eine Speicherkapazität von 256 KBit bis 16 MBit. Die dynamische Speichereinheit 112 ist im Gegensatz zur statischen Speichereinheit 102 nicht datenwortweise sondern bitweise organisiert. Aus diesem Grund gibt es an der dynamischen Speichereinheit 112 nur einen Datenanschluß DATA, der über eine Datenleitung 114 mit dem Anschluß 3 der Speicherzugriffseinheit 100 verbunden ist.

Auch die dynamische Speichereinheit 112 hat einen Schreib/Lese-Auswahlanschluß $\overline{WE}$, der über eine Steuerleitung 116 mit dem Anschluß 8 der Speicherzugriffseinheit 100 verbunden ist. Abhängig vom Potential auf der Steuerleitung 116 wird die dynamische Speichereinheit 112 im Schreibmodus oder im Lesemodus betrieben.

Ein Steueranschluß $\overline{RAS}$ (Row Address Strobe) der dynamischen Speichereinheit 112 ist über eine Steuerleitung 118 mit dem Anschluß 5 der Speicherzugriffseinheit 100 verbunden. Ein Steueranschluß $\overline{CAS}$ der dynamischen Speichereinheit 112 ist über eine Steuerleitung 120 mit dem Anschluß 4 der Speicherzugriffseinheit 100 verbunden.

Adreßanschlüsse A0 bis A11 der dynamischen Speichereinheit 112 sind über einen Adreßbus 122 mit Anschlüssen 9 bis 20 der Speicherzugriffseinheit 100 verbunden. Zunächst wird an den Adreßanschlüssen A0 bis A11 eine Spaltenadresse angelegt. Anschließend wird am Steueranschluß $\overline{RAS}$ durch die Speicherzugriffseinheit 100 ein L-Potential erzeugt. Aufgrund dieses L-Potentials wird die über den äußeren Adreßbus 122 signalisierte Adresse als Spaltenadresse zur Adressierung der Speichereinheit 122 verwendet. Danach wird an den Adreßanschlüssen A0 bis A11 eine Zeilenadresse übertragen. Wird das Steuersignal $\overline{CAS}$ durch die Speicherzugriffseinheit 100 auf L-Potential geschaltet, so wird die an den Adreßanschlüssen A0 bis A11 übertragene Adresse als Zeilenadresse für die Adressierung der Speichereinheit 112 verwendet.

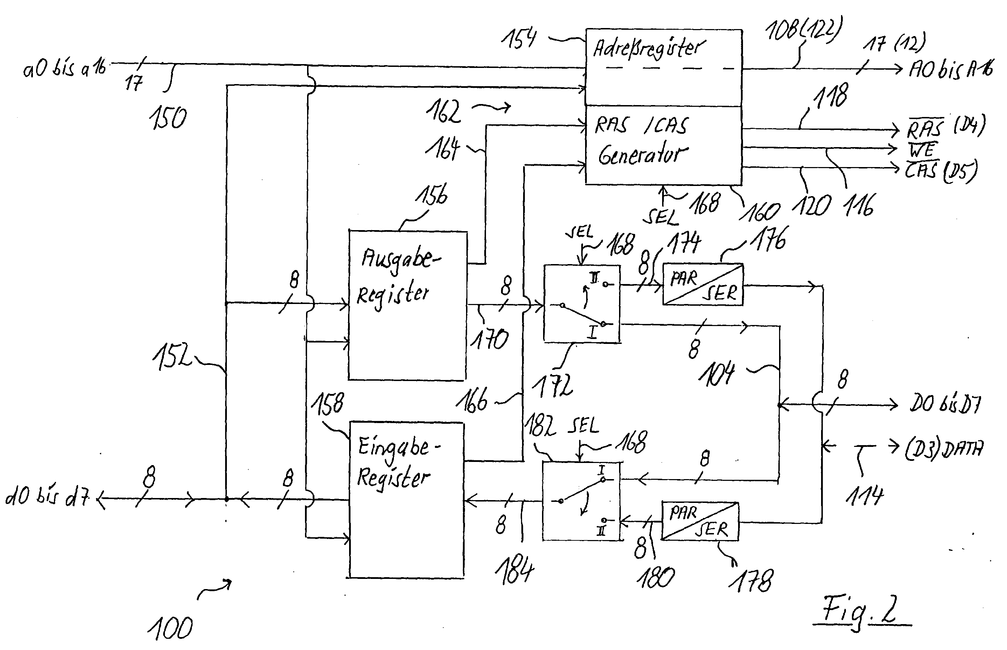

Figur 2 zeigt den Aufbau der Speicherzugriffseinheit 100, die einen inneren Adreßbus 150 mit 17 Adreßleitungen a0 bis a16 und einen inneren Datenbus 152 mit acht Datenleitungen d0 bis d7 enthält. Der innere Adreßbus 150 ist mit den Adreßanschlüssen eines nicht dargestellten Prozessors verbunden. Die Datenanschlüsse des Prozessors sind mit den Datenleitungen d0 bis d7 des Datenbusses 152 verbunden.

Die Speicherzugriffseinheit 100 enthält ein Adreßregister 154, ein Ausgaberegister 156 und ein Eingaberegister 158, die jeweils mit dem inneren Adreßbus 150 und dem inneren Datenbus 152 verbunden sind. Über den inneren Adreßbus 150 kann das jeweilige Register 154, 156 bzw. 158 vom Prozessor aus adressiert werden. Die Registerinhalte werden mit Hilfe des Datenbusses 152 vom Prozessor ausgelesen oder geschrieben. Der Zugriff erfolgt dabei auf dasjenige Register 152, 154 bzw. 156, dessen Adresse am Adreßbus 150 anliegt.

Das Adreßregister 154 bildet gemeinsam mit einer Signaleinheit 160 eine Adressiereinheit 162. Die Adressiereinheit 162 ist ausgangsseitig mit dem äußeren Adreßbus 108 bzw. 122 verbunden. Die Signaleinheit 160 ist ausgangsseitig mit den Steuerleitungen 116, 118 und 120 verbunden. Vom Ausgaberegister 156 führt eine Schreibleitung 164 zur Adressiereinheit 162. Vom Eingaberegister 158 führt eine Leseleitung 166 zur Adressiereinheit 154. Eine Betriebsartleitung 168 führt ebenfalls zur Adressiereinheit 154. Über die Betriebsleitung 168 wird eingestellt, ob die Speicherzugriffseinheit 100 in einer SRAM-Betriebsart I für den Zugriff auf die statische Speichereinheit 102 oder in einer DRAM-Betriebsart II für den Zugriff auf die dynamische Speichereinheit 112 betrieben wird.

Das Ausgaberegister 156 ist ausgangsseitig mit acht Datenleitungen eines Datenbusses 170 verbunden, der zu einer Umschalteinheit 172 führt. Die Datenleitungen des Datenbusses 170 können wahlweise mit den acht Datenleitungen eines Datenbusses 174 bzw. mit den acht Datenleitungen des Datenbusses 104 verbunden werden. Die Umschalteinheit 172 wird abhängig vom Potential auf der Betriebsartleitung 168 geschaltet. Der Datenbus 174 führt zu einem Parallel-Seriell-Wandler 176, dessen Ausgang mit der Datenleitung 114 verbunden ist.

Die Datenleitung 114 führt außerdem zum Eingang eines Seriell-Parallel-Wandlers 178, dessen Ausgang mit einem Datenbus 180 verbunden ist. Der Datenbus 180 enthält acht Datenleitungen und führt zu dem einen Eingang einer Umschalteinheit 182. Der andere Eingang der Umschalteinheit 182 ist mit dem äußeren Datenbus 104 verbunden. Die Umschalteinheit 182 verbindet abhängig von der über die Betriebsartleitung 168 eingestellten Betriebsart entweder den Datenbus 180 oder den Datenbus 104 mit einem Datenbus 184 am Ausgang der Umschalteinheit 182. Der Datenbus 184 führt zu den Eingängen des Eingaberegisters 158.

Zunächst soll die Funktion der Speicherzugriffseinheit 100 in der SRAM-Betriebsart I erläutert werden. In dieser Betriebsart verbindet die Umschalteinheit 168 den Datenbus 170 mit dem äußeren Datenbus 104. Die Umschalteinrichtung 182 verbindet den äußeren Datenbus 104 mit dem Datenbus 184. Die Signalisierungseinheit 160 erzeugt nur Steuersignale auf der Steuerleitung 116 für den Schreib/Lese-Auswahlanschluß $\overline{WE}$.

Beim Schreiben eines Datenwortes in die statische Speichereinheit 102 erzeugt der Prozessor zunächst auf dem inneren Adreßbus 150 ein Adreßwort, das das Adreßregister 154 adressiert. Gleichzeitig wird auf dem inneren Datenbus D0 bis D7 vom Prozessor ein Datenwort in die oberen Bitstellen des Adreßregisters 154 geschrieben. Danach wird bei gleichbleibendem Adreßwort auf dem inneren Adreßbus a0 bis a16 der niederwertige Teil des Adreßregisters durch den Prozessor beschrieben. Dabei wird ein Datenwort auf den inneren Datenbus 152 übertragen. Im Adreßregister 154 befindet sich nun ein Adreßwort, dessen Wert die Speicherzelle der statischen Speichereinheit 102 angibt, in welche ein Datenwort geschrieben werden soll.

Der Prozessor adressiert danach über den inneren Adreßbus 150 das Ausgaberegister 152 und schreibt gleichzeitig das später in die Speichereinheit 102 zu übertragende Datenwort über den inneren Datenbus 152 in das Ausgaberegister 156. Im Ausgaberegister 156 wird aufgrund der Adressierung dieses Ausgaberegisters 156 auf der Schreibleitung 164 ein Signal erzeugt, welches der Adreßeinheit 162 signalisiert, daß der Zugriff auf die Speichereinheit 102 beginnen kann. Das im Ausgaberegister 156 gespeicherte Datenwort gelangt über den Datenbus 150, die Umschalteinheit 172 zum äußeren Datenbus 104. Die Adressiereinheit 154 steuert das Schreiben des Datenwortes in die Speichereinheit 102. Dabei wird auf dem äußeren Adreßbus 108 ein Adreßwort übertragen, das dem im Adreßregister 154 gespeicherten Adreßwert entspricht.

Zum Lesen der Speichereinheit 102 muß der Prozessor zunächst über den inneren Adreßbus 150 das Adreßregister 154 adressieren und in das Adreßregister 154 über den inneren Datenbus 152 ein Adreßwort eingeben, dessen Wert die zu lesende Speicherzelle der Speichereinheit 102 festlegt. Anschließend wird das Eingaberegister 158 vom Prozessor über den inneren Adreßbus 150 adressiert. Gleichzeitig wird über den inneren Datenbus 152 ein Datenwort aus dem Eingaberegister 158 gelesen. Dieses Datenwort wird vom Prozessor nicht weiter bearbeitet. Durch das Lesen des Eingaberegisters 158 wird auf der Leseleitung 166 ein Signal erzeugt, welches der Adressiereinheit 162 signalisiert, daß das Lesen der Speichereinheit 102 beginnen kann. Die Adressiereinheit 154 sendet das im Adreßregister 154 gespeicherte Adreßwort über den äußeren Adreßbus 108 an die Speichereinheit 102. Daraufhin werden am äußeren Datenbus 104 Daten des zu lesenden Datenwortes ausgegeben. Diese Daten gelangen über die Umschalteinheit 182 und den Datenbus 184 in das Eingaberegister 158. Der Prozessor liest in einem folgenden Schritt dieses Datenwort aus dem Eingaberegister 158, wobei dieses Eingaberegister 158 über den inneren Adreßbus 150 adressiert ist.

Wird der im Adreßregister 154 gespeicherte Wert nach jedem Lesezugriff automatisch erhöht, so lassen sich aus dem Eingaberegister 158 die Datenworte aus Speicheradressen mit aufeinanderfolgenden Adreßwerten mit einer Verzögerung von einem Lesezugriff auslesen, ohne daß vom Prozessor mehr Schritte als bei einem direkten Zugriff auf die Speichereinheit 102 auszuführen sind.

In der DRAM-Betriebsart II verbindet die Umschalteinheit 172 den Datenbus 170 mit dem Datenbus 174. Die Umschalteinheit 182 verbindet den Datenbus 180 mit dem Datenbus 184. Die Signaleinheit 160 erzeugt die für den Zugriff auf die dynamische Speichereinheit 112 erforderlichen Signale auf den Steuerleitungen 116, 118 und 120.

Zum Schreiben eines Datenwortes in die Speichereinheit 112 lädt der Prozessor zunächst den Adreßwert der zu schreibenden Speicherzelle in das Adreßregister 154, wie oben erläutert. Anschließend adressiert der Prozessor über den inneren Adreßbus 150 das Ausgaberegister 156. Gleichzeitig wird das zu schreibende Datenwort über den inneren Datenbus 152 in das Ausgaberegister 156 geschrieben. Dies verursacht ein Startsignal auf der Schreibleitung 164. Aufgrund des Startsignals führt die Adressiereinheit 152 einen Lesezugriff auf die Speichereinheit 112 durch. Dabei wird zunächst der niederwertige Teil des Adreßdatenwortes im Adreßregister 154 am äußeren Adreßbus 122 ausgegeben. Gleichzeitig wird das Steuersignal $\overline{RAS}$ auf L-Pegel geschaltet. Danach wird der höherwertige Teil des im Adreßregister gespeicherten Adreßwortes über den äußeren Datenbus 122 ausgegeben und das Steuersignal $\overline{CAS}$ auf L-Pegel gesetzt. Das Datum in der niederwertigsten Bitstelle des im Ausgaberegister 156 gespeicherten Datenwortes wird am Ausgang des Parallel-Seriell-Wandlers 176 ausgegeben und in die im Adreßregister 154 angegeben Speicherzelle der Speichereinheit 112 geschrieben. Anschließend werden automatisch sieben weitere Speicherzellen mit den nächstfolgenden sieben Adreßwerten mit Daten beschrieben, die nacheinander am Ausgang des Parallel-Seriell-Wandlers 156 ausgegeben werden.

Beim Lesen der Speichereinheit 112 überträgt der Prozessor zunächst wieder in das Adreßregister 154 ein Adreßwort, dessen Wert die zu lesende Speicherzelle der Speichereinheit 112 angibt. Anschließend wird vom Prozessor ein Lesezugriff auf das Eingaberegister 158 durchgeführt. Dieser Lesezugriff hat zur Folge, daß über die Leseleitung 166 automatisch ein von der Adressiereinheit 162 ausgeführter Lesezugriff auf die Speichereinheit 112 gestartet wird. Zunächst wird ein Datum an einer Speicherzelle ausgelesen, deren Adreßwert im Adreßregister 154 gespeichert ist. Dieses Datum gelangt über die Datenleitung 114 zum Eingang des Seriell-Parallel-Wandlers 178. Danach werden automatisch die Daten aus sieben Speicherzellen ausgelesen, deren Adreßwerte dem Wert des im Adreßregister 154 gespeicherten Adreßwortes folgen. Auch diese Daten gelangen zum Seriell-Parallel-Wandler 178. Am Ausgang des Wandlers 178 wird nach dem achten Lesezugriff ein Datenwort ausgegeben und in das Eingaberegister 158 geschrieben.

Der Prozessor liest in einem zweiten Lesezugriff aus dem Eingaberegister 158 nun das dort gespeicherte Datenwort aus, das zur weiteren Bearbeitung genutzt wird. Die Lesezugriffe des Prozessors auf das Eingaberegister 158 erfolgen in beiden Betriebsarten mit gleichen zeitlichen Abständen. Der zeitliche Abstand wird durch die Dauer des Speicherzugriffs in der langsameren Betriebsart vorgegeben.

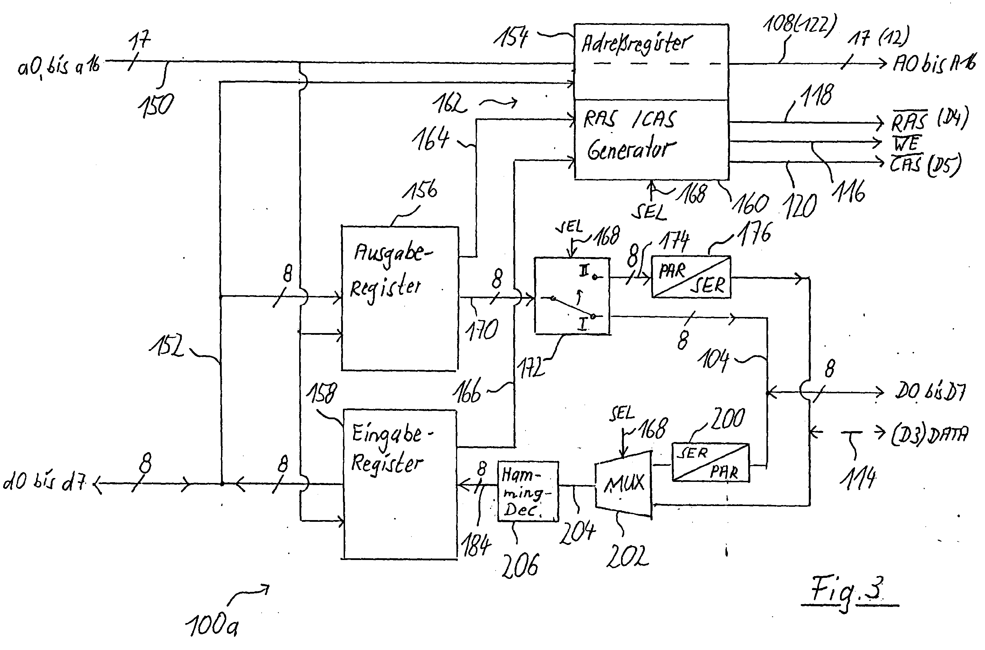

Figur 3 zeigt den Aufbau einer Speicherzugriffseinheit 100a gemäß einem zweiten Ausführungsbeispiel. Gleiche Bestandteile der Speicherzugriffseinheit 100 und 100a sind mit gleichen Bezugszeichen gekennzeichnet. Die Speicherzugriffseinheit 100a enthält keine Umschalteinheit 182 und keinen Seriell-Parallel-Wandler 178. Der äußere Datenbus 104 führt zu den Eingängen eines Parallel-Seriell-Wandlers 200. Der Ausgang des Wandlers 200 ist mit dem Eingang eines Multiplexers 202 verbunden. Der andere Eingang des Multiplexers 202 ist mit der Datenleitung 114 verbunden. Am Steuereingang des Multiplexers 202 ist die Betriebsartleitung 168 angeschlossen. In der SRAM-Betriebsart I wird der mit dem Wandler 200 verbundene Eingang des Multiplexers 202 mit dessen Ausgang verbunden. In der DRAM-Betriebsart II wird der mit der Datenleitung 114 verbundene Eingang des Multiplexers 202 mit dem Ausgang des Multiplexers 202 verbunden. Am Ausgang des Multiplexers 202 ist eine Verbindungsleitung 204 angeschlossen, die zum Eingang eines Hamming-Decoders 206 führt. Acht Ausgänge des Hamming-Decoders 206 sind mit den Datenleitungen des Datenbusses 184 verbunden. Im übrigen stimmt der Aufbau der Speicherzugriffseinheit 100a mit dem Aufbau der Zugriffseinheit 100 überein.

Im folgenden sollen nur die Unterschiede in der Funktionsweise der Speicherzugriffseinheiten 100 und 100a erläutert werden. Datenworte, die in die Speichereinheit 102 bzw. in die Speichereinheit 112 geschrieben werden sollen, werden zunächst gemäß dem sogenannten Hammingcode codiert. Der Zugriff auf die Speichereinheit 102 bzw. 112 erfolgt dann so wie oben für die Speicherzugriffseinheit 100 erläutert.

Beim Lesen der Speichereinheit 102 in der SRAM-Betriebsart I wird ein auf dem äußeren Datenbus 104 übertragenes Datenwort vom Seriell-Parallel-Wandler 200 in mehrere Daten zerlegt, die nacheinander über den Multiplexer 200 zum Hammingdecoder 206 gelangen. Der Hammingdecoder 206 decodiert die Daten gemäß Hammingcode und korrigiert dabei Fehler. Am Ausgang des Hammingdecoders 206 wird dann ein decodiertes Datenwort in das Eingaberegister 158 geschrieben. Die anderen Vorgänge beim Lesen der Speichereinheit 102 in der Betriebsart I stimmen mit den oben für die Speicherzugriffseinheit 100 erläuterten Vorgängen überein.

Beim Lesen der Speichereinheit 112 in der DRAM-Betriebsart II gelangen nacheinander acht Daten über die Datenleitung 114 zum Multiplexer 202 und dann zum Hammingdecoder 206. Im Hammingdecoder 206 werden diese Daten decodiert und am Ausgang des Hammingdecoders 206 wird ein Datenwort erzeugt, das im Eingaberegister 158 gespeichert wird. Im übrigen stimmen die Vorgänge beim Lesen der Speichereinheit 112 mit den oben erläuterten Vorgängen überein.

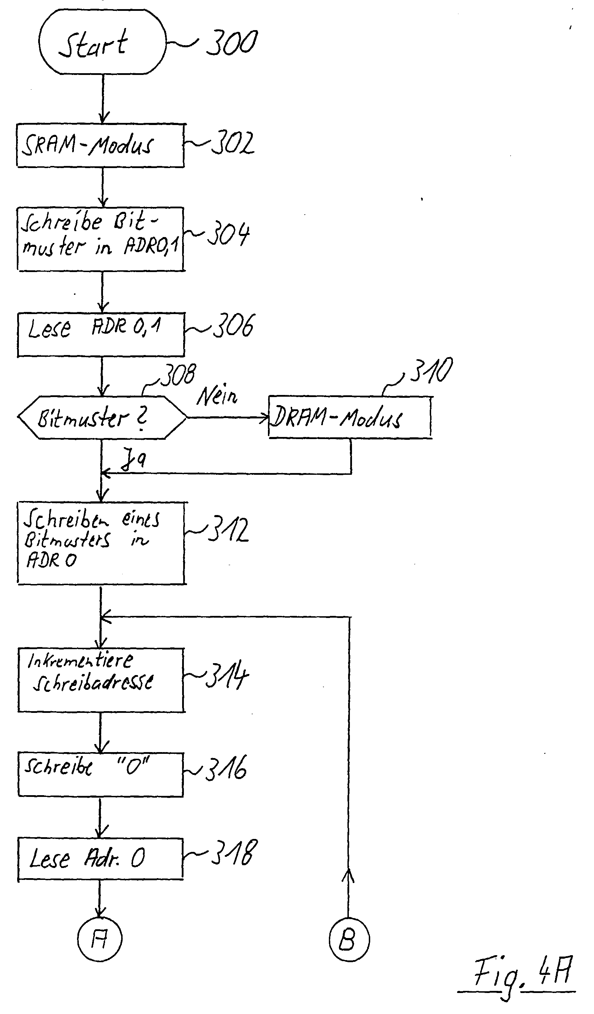

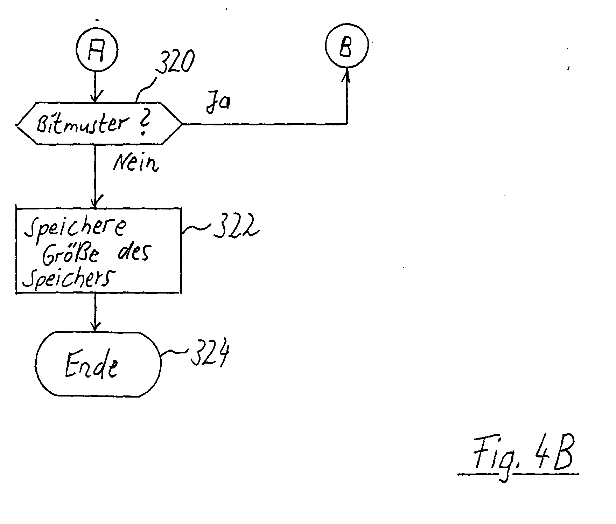

Die Figuren 4A und 4B zeigen ein Flußdiagramm mit Verfahrensschritten zum automatischen Ermitteln der Betriebsart I bzw. II sowie zum Ermitteln der Speicherkapazität der Speichereinheit 102 bzw. 112. Das Verfahren beginnt in einem Schritt 300. In einem Schritt 302 wird die Betriebsart I vorgegeben, In einem folgenden Schritt 304 werden zwei verschiedene Bitmuster an die Adresse ADR0 und ADR1 geschrieben. Das Schreiben verschiedener Bitmuster gewährleistet, daß die Erkennung sicher durchgeführt werden kann, auch wenn zufällig in der Speichereinheit Bitmuster gespeichert sind, die mit dem ersten oder mit dem zweiten Bitmuster übereinstimmen.

In einem Verfahrensschritt 306 werden die Adressen ADR0 und ADR1 gelesen. In einem Verfahrensschritt 308 wird überprüft, ob die gelesenen Datenworte mit dem im Verfahrensschritt 304 verwendeten Bitmustern übereinstimmen. Ist dies nicht der Fall, so wird in einem Verfahrensschritt 310 die Betriebsart II vorgegeben, d.h. die DRAM-Betriebsart. Anschließend wird das Verfahren in einem Verfahrensschritt 312 fortgesetzt.

Nach dem Verfahrensschritt 308 folgt der Verfahrensschritt 312 unmittelbar, wenn im Verfahrensschritt 308 festgestellt worden ist, daß die im Verfahrensschritt 306 gelesenen Datenworte mit den im Verfahrensschritt 304 verwendeten Bitmustern übereinstimmen. In diesem Fall wird die Betriebsart nicht geändert.

Im Verfahrensschritt 312 wird an die Adresse ADR0 ein weiteres Bitmuster geschrieben, z.B. der hexadezimale Wert 13. In einem Verfahrensschritt 314 wird die Schreibadresse um einen vorgegebenen Wert erhöht. Das Inkrementieren der Schreibadresse im Verfahrensschritt 314 kann in größeren Schritten durchgeführt werden, z.B. in 16 KB-Schritten.

In einem Verfahrensschritt 316 wird an die aktuelle Schreibadresse der Wert 0 geschrieben. In einem folgenden Verfahrensschritt 318 wird die Adresse ADR0 gelesen. In einem Verfahrensschritt 320 wird der im Verfahrensschritt 318 gelesene Wert mit dem im Verfahrensschritt 312 verwendeten Bitmuster verglichen. Wird Übereinstimmung festgestellt, so wird das Verfahren im Schritt 314 fortgesetzt. Damit befindet sich das Verfahren in einer Verfahrensschleife aus den Verfahrensschritten 314 bis 320, die so lange durchlaufen wird, bis im Verfahrensschritt 320 festgestellt wird, daß in der Adresse ADR0 nicht mehr das im Verfahrensschritt 312 gespeicherte Bitmuster gespeichert ist. Dies ist darauf zurückzuführen, daß die Schreibadresse 314 so lange erhöht worden ist, bis wieder der Adreßwert ADR0 erreicht worden ist.

Wurde das in der Adresse ADR0 gespeicherte Bitmuster überschrieben, so folgt nach dem Verfahrensschritt 320 unmittelbar Verfahrensschritt 322. Im Verfahrensschritt 322 wird die Größe des Speichers für die spätere Bearbeitung in einem Register vermerkt. Anschließend wird das Verfahren in einem Verfahrensschritt 324 beendet.

**Patentansprüche**

1. Speicherzugriffseinheit (100, 100a) für den wahlweisen Zugriff auf eine statische Speichereinheit (102) oder eine dynamische Speichereinheit (112),

   mit einem inneren Adreßbus (150), der eine vorgegebene Anzahl innerer Adreßleitungen zum Übertragen eines inneren Adreßwortes enthält,
   einem inneren Datenbus (152), der mehrere innere Datenleitungen zum Übertragen eines inneren Datenwortes enthält,
   einem äußeren Adreßbus (108, 122), der eine vorgegebene Anzahl äußerer Adreßleitungen zum Adressieren einer statischen Speichereinheit (102) in einer ersten Betriebsart (I) und zum Adressieren einer dynamischen Speichereinheit (112) in einer zweiten Betriebsart (II) abhängig von einem inneren Adreßwort enthält,
einem äußeren Datenbus (104, 114), der eine vorgegebene Anzahl Datenleitungen zum Übertragen von Daten von oder zur Speichereinheit (102, 112) enthält,
und mit einer Steuereinheit, die abhängig von der gewählten Betriebsart (I, II) die Weitergabe eines inneren Adreßwortes auf den äußeren Adreßbus (108, 122) sowie die Datenübertragung zwischen innerem Datenbus (152) und äußerem Datenbus (104, 114) steuert,
**gekennzeichnet** durch ein zum Speichern des weiterzugebenden inneren Adreßwortes dienendes Adreßregister (154), dessen Adreßanschlüsse mit dem inneren Adreßbus (150) und dessen Datenanschlüsse mit dem inneren Datenbus (152) verbunden sind,
mindestens einem zum Zwischenspeichern eines bereits über den äußeren Datenbus (104, 114) übertragenen oder noch vom äußeren Datenbus (104, 114) zu übertragenden Datenwortes dienendes Datenregister (156, 158), dessen Adreßanschlüsse mit dem inneren Adreßbus (150) und dessen Datenanschlüsse mit dem inneren Datenbus (152) verbunden sind.

2. Speicherzugriffseinheit (100) nach Anspruch 1, **gekennzeichnet** durch ein erstes Datenregister (156), dessen Adresse auf dem inneren Adreßbus (150) beim Schreiben eines inneren Datenwortes anliegt,

   und durch ein zweites Datenregister (158), dessen Adresse von der Adresse des ersten Datenregisters (156) abweicht und das beim Lesen eines inneren Datenwortes über den inneren Adreßbus (150) adressiert wird.

3. Speichereinheit (100) nach Anspruch 2, dadurch **gekennzeichnet**, daß beim Schreiben eines Datenwortes in das erste Datenregister (156) die Steuereinheit automatisch das Datenwort in die Speichereinheit (102, 112) an die dem Adreßregister (154) gespeicherte Adresse schreibt,

   und/oder das beim Lesen des zweiten Datenregisters (158) oder beim Schreiben des Adreßregisters (154) die Steuereinheit automatisch aus der Speichereinheit (102, 112) ein Datenwort liest, das an der im Adreßregister (154) gespeicherten Adresse gespeichert ist.

4. Speichereinheit (100) nach einem der vorhergehenden Ansprüche, dadurch **gekennzeichnet**, daß mindestens eine Leitung des äußeren Adreßbusses (150) oder des äußeren Datenbusses (104, 114) unabhängig von der Betriebsart (I, II) die gleiche Funktion hat,

und/oder daß mindestens eine weitere Leitung des äußeren Adreßbusses (150) oder des äußeren Datenbusses (104, 114) abhängig von der Betriebsart (I, II) verschiedene Funktionen hat.

**5.** Speichereinheit (100) nach einem der vorhergehenden Ansprüche, dadurch **gekennzeichnet**, daß zwischen äußerem Datenbus (104, 114) und innerem Datenbus (152) mindestens ein Datenwandler (156, 178, 200) geschaltet ist, der seriell übertragene Daten gleichzeitig als ein Datenwort ausgibt oder der gleichzeitig eingegebene Daten eines Datenwortes seriell ausgibt.

**6.** Speichereinheit (100) nach einem der vorhergehenden Ansprüche, **gekennzeichnet** durch einen zwischen äußerem Datenbus (104, 114) und innerem Datenbus (152) angeordnete Decodiereinheit (206) zum Erkennen und/oder Korrigieren von Fehlern bei der Übertragung von Datenworten.

**7.** Verfahren zum wahlweisen Zugriff auf eine statische Speichereinheit (102) oder eine dynamische Speichereinheit (112),

bei dem ein Prozessor ein Adreßwort in einem Adreßregister (154) speichert, der Prozessor ein Datenwort in einem Datenregister (156) speichert,
und bei dem abhängig von einer gewählten Betriebsart (I, II) das gespeicherte Datenwort in eine statische Speichereinheit (102) oder in eine dynamische Speichereinheit (104) an der durch das Adreßwort angegebenen Adresse geschrieben wird.

**8.** Verfahren zum wahlweisen Zugriff auf eine statische Speichereinheit (102) oder eine dynamische Speichereinheit (112),

bei dem ein Prozessor ein Adreßwort in einem Adreßregister (154) speichert, der Prozessor ein Datenwort aus einem Datenregister (158) liest,
und bei dem abhängig von einer gewählten Betriebsart (I, II) ein Datenwort aus einer statischen Speichereinheit (102) oder aus einer dynamischen Speichereinheit (112) an der durch das Adreßwort angegebenen Adresse gelesen und im Datenregister (158) gespeichert wird.

**9.** Verfahren nach Anspruch 7 oder 8, dadurch **gekennzeichnet**, daß das Schreiben des Adreßregisters (154) und der Zugriff auf das Datenregister (156, 158) durch den Prozessor unabhängig von der gewählten Betriebsart (I, II) erfolgen.

**10.** Verfahren nach einem der Ansprüche 7 bis 9, dadurch **gekennzeichnet**, daß die Betriebsart (I, II) durch den Prozessor automatisch ermittelt wird.

**a)**

SRAM
256 / 1 Mbit

A0 bis A16        $\overline{WE}$        D0 bis D7

17
108        104        8        102
106

9 bis 25        8        0 bis 7

110    $I^2C$-Bus        100

**b)**

DRAM
256 bis 16 Mbit

A0 bis A11    $\overline{CAS}$  $\overline{RAS}$  $\overline{WE}$        DATA

12        112
122    120    118    116        114

9 bis 20    4    5    8        3

110    $I^2C$ Bus        100

Fig. 1

Fig. 2

EP 1 089 288 A1

Fig. 3

EP 1 089 288 A1

```
        ┌─────────┐
        │  Start  │ ─── 300
        └─────────┘
             │
             ▼
   ┌───────────────────┐
   │   SRAM-Modus      │ ─── 302
   └───────────────────┘
             │
             ▼
   ┌───────────────────┐
   │  Schreibe Bit-    │ ─── 304
   │  muster in ADR0,1 │
   └───────────────────┘
             │
             ▼
   ┌───────────────────┐
   │   Lese  ADR 0,1   │ ─── 306
   └───────────────────┘
             │          308          Nein           310
             ▼    ╱──────────╲              ┌───────────────┐
          ⟨  Bitmuster ?  ⟩ ───────────────▶│  DRAM-Modus   │
             ╲──────────╱                    └───────────────┘
             │  Ja                                  │
             ▼◀───────────────────────────────────┘
   ┌───────────────────┐
   │  Schreiben eines  │ ─── 312
   │  Bitmusters in    │
   │  ADR 0            │
   └───────────────────┘
             │
             ▼◀──────────────────────────┐
   ┌───────────────────┐                 │
   │  Inkrementiere    │ ─── 314         │
   │  Schreibadresse   │                 │
   └───────────────────┘                 │
             │                           │
             ▼                           │
   ┌───────────────────┐                 │
   │  Schreibe  "0"    │ ─── 316         │
   └───────────────────┘                 │
             │                           │
             ▼                           │
   ┌───────────────────┐                 │
   │   Lese Adr. 0     │ ─── 318         │
   └───────────────────┘                 │
             │                           │
             ▼                           │
           ┌───┐                       ┌───┐
           │ A │                       │ B │
           └───┘                       └───┘
```

Fig. 4A

Fig. 4B

Europäisches
Patentamt

**EUROPÄISCHER RECHERCHENBERICHT**

**Nummer der Anmeldung**

EP 00 11 8860

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int.Cl.7) |
|---|---|---|---|
| X | EP 0 571 099 A (SUN MICROSYSTEMS INC) 24. November 1993 (1993-11-24) | 7 | G11C11/418 G11C11/419 |
| A | * das ganze Dokument * | 1-6 | |
| X | US 5 918 242 A (YANES ADALBERTO GUILLERMO ET AL) 29. Juni 1999 (1999-06-29) * Spalte 9, Zeile 22 - Zeile 42; Abbildungen 2,6 * | 8-10 | |
| A | US 5 694 585 A (DWIN DAVID ET AL) 2. Dezember 1997 (1997-12-02) * Spalte 12, Zeile 16 - Zeile 28; Abbildungen 3,3A * | 1,7 | |
| A | US 5 740 466 A (YOON TONY J ET AL) 14. April 1998 (1998-04-14) * Spalte 2, Zeile 65 - Spalte 4, Zeile 17; Abbildung 1 * | 7 | |
| A | US 5 848 247 A (NARITA SUSUMU ET AL) 8. Dezember 1998 (1998-12-08) * Zusammenfassung; Abbildungen 1,3,5 * | 7,8 | **RECHERCHIERTE SACHGEBIETE (Int.Cl.7)** G11C |
| A | US 5 634 105 A (MIZUNO KANJI) 27. Mai 1997 (1997-05-27) * Zusammenfassung; Abbildung 1 * | 1 | |

Der vorliegende Recherchenbericht wurde für alle Patentansprüche erstellt

| Recherchenort | Abschlußdatum der Recherche | Prüfer |
|---|---|---|
| DEN HAAG | 8. Januar 2001 | Wolff, N |

KATEGORIE DER GENANNTEN DOKUMENTE

X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder nach dem Anmeldedatum veröffentlicht worden ist
D : in der Anmeldung angeführtes Dokument
L : aus anderen Gründen angeführtes Dokument
........................................................................
& : Mitglied der gleichen Patentfamilie, übereinstimmendes Dokument

EPO FORM 1503 03.82 (P04C03)

**ANHANG ZUM EUROPÄISCHEN RECHERCHENBERICHT
ÜBER DIE EUROPÄISCHE PATENTANMELDUNG NR.**          EP 00 11 8860

In diesem Anhang sind die Mitglieder der Patentfamilien der im obengenannten europäischen Recherchenbericht angeführten
Patentdokumente angegeben.
Die Angaben über die Familienmitglieder entsprechen dem Stand der Datei des Europäischen Patentamts am
Diese Angaben dienen nur zur Unterrichtung und erfolgen ohne Gewähr.

08-01-2001

| Im Recherchenbericht angeführtes Patentdokument | Datum der Veröffentlichung | Mitglied(er) der Patentfamilie | Datum der Veröffentlichung |
|---|---|---|---|
| EP 0571099 A | 24-11-1993 | US 5265218 A<br>DE 69322310 D<br>DE 69322310 T<br>JP 6318182 A<br>KR 219359 B<br>SG 65572 A | 23-11-1993<br>14-01-1999<br>27-05-1999<br>15-11-1994<br>01-09-1999<br>22-06-1999 |
| US 5918242 A | 29-06-1999 | KEINE | |
| US 5694585 A | 02-12-1997 | KEINE | |
| US 5740466 A | 14-04-1998 | US 5524268 A | 04-06-1996 |
| US 5848247 A | 08-12-1998 | JP 8320823 A<br>JP 8095943 A<br>US 6049844 A | 03-12-1996<br>12-04-1996<br>11-04-2000 |
| US 5634105 A | 27-05-1997 | KEINE | |

EPO FORM P0461

Für nähere Einzelheiten zu diesem Anhang : siehe Amtsblatt des Europäischen Patentamts, Nr.12/82